# EUROPEAN PATENT SPECIFICATION

(11) **EP 4 425 541 B1**
(45) Date of publication and mention of the grant of the patent: **09.12.2026**
(21) Application number: 24160991.6
(22) Date of filing: 01.03.2024
(51) Int. Cl.: H10D 86/01, H10D 86/00, H10W 40/22, H10W 40/25

(54) **HEAT SINK FOR SOI**
SOI-WÄRMESENKE
DISSIPATEUR THERMIQUE POUR SOI

(30) Priority: 03.03.2023 US 202363449761 P; 21.02.2024 US 202418583280
(43) Date of publication of application: 04.09.2024
(73) Proprietor: Qorvo US, Inc., Greensboro, NC 27409 (US)
(72) Inventor: SCOTT, Baker, San Jose (US); LIU, Xiong, San Jose (US); MAXIM, George, San Jose (US); FRANCK, Stephen James, San Jose (US)
(74) Representative: D Young & Co LLP

(56) References cited:
- US-A1- 2002 158 276
- US-A1- 2006 278 901
- US-A1- 2007 111 409
- US-A1- 2013 164 891

## Description

### Related Applications

This application claims the benefit of provisional patent application serial number 63/449,761, filed March 3, 2023, and patent application serial number 18/583,280, filed 21 February 2024.

### Field

This disclosure relates generally to integrated circuit devices.

### Background

Amplifiers, such as power amplifiers and low noise amplifiers, are being implemented on silicon on insulator SOI substrates. The primary problem with these amplifiers is heat dissipation. In particular, the insulating layer under the amplifiers is not a good thermal conductor and thus heat dissipation is a problem in these configurations. While SOI substrates offer the advantage of reduced losses and distortions in amplifiers, heat flow is a problem since the insulating layer prevents heat from dissipating out of the SOI substrate.

### Summary

Particular aspects are set out in the appended independent claims. Various optional embodiments are set out in the dependent claims.

In some embodiments, an integrated circuit (IC) device includes a semiconductor substrate; a buried oxide (BOX) layer formed over the semiconductor substrate; a semiconductor layer formed over the BOX layer; a field effect transistor, including: a drain formed in a first active section of the semiconductor layer, the first active section having a first width with respect to a first horizontal direction; a source formed in a second active section of the semiconductor layer, the second active section having a second width with respect to the first horizontal direction; an extended active section that extends from the second active section, the extended section having a third width relative to the first horizontal direction, wherein the second width added to the third width is equal to or greater than five times the first width; a thermal heat sink connected to the second active region and the extended active region and extending above the semiconductor layer. In some embodiments, the thermal heat sink has a fourth width with respect to first horizontal direction, wherein the fourth width is substantially equal to the second width plus the third width. In some embodiments, the extended active section is an extension of the source such that the second active section and the extended active section form an active region. In some embodiments, one or more diodes are formed in the extended section. According to the invention, the IC devices further includes a ground plate, wherein the thermal heat sink is connected to the ground plate.

In some embodiments, an IC device includes a semiconductor substrate; a BOX layer formed over the semiconductor substrate; a semiconductor layer formed over the BOX layer; a first area in the semiconductor layer, wherein the first area includes first active sections one or more first field effect transistors (FETs) a second area in the semiconductor layer, wherein the second area includes second active sections of one or more second FETs; an extended active section that is provided between the first area and the second area; a thermal heat sink connected to first area, the second area, and the extended active section. In some embodiments, the extended active section is an extension of a first one of the first active sections in the first area and an extension of a first one of the second active sections of a first one of the one or more second FETs in the second area. In some embodiments, one or more diodes are formed in the extended section. According to the invention, the IC device further includes a ground plate, wherein the thermal heat sink is connected to the ground plate.

In some embodiments, a method of manufacturing an IC device, includes: providing a semiconductor substrate; forming a BOX layer over the semiconductor substrate; forming a semiconductor layer over the BOX layer, wherein; the semiconductor layer includes a first area in the semiconductor layer, wherein the first area includes first active sections of one or more first FETs; the semiconductor layer includes a second area in the semiconductor layer, wherein the second area includes second active sections of one or more second FETs; the semiconductor layer includes an extended active section that is provided between the first area and the second area; forming a thermal heat sink connected to first area, the second area, and the extended active section.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
FIG. 1 is a cross-sectional diagram of an integrated circuit (IC) device, in accordance with some embodiments.
FIG. 2 is a diagram of an IC device, in accordance with some embodiments.
FIG. 3 is a diagram of an IC device, in accordance with some embodiments.
FIG. 4 is a diagram of an IC device, in accordance with some embodiments.
FIG. 5 is a diagram of an IC device, in accordance with some embodiments.
FIG. 6 is a diagram of an IC device, in accordance with some embodiments.
FIG. 7 is a diagram of an IC device, in accordance with some embodiments.
FIG. 8A and FIG. 8B are diagrams of an IC device, in accordance with some embodiments.
FIG. 9A and FIG. 9B are diagrams of an IC device, in accordance with some embodiments.
FIG. 10 is a layout diagram of an IC device, in accordance with some embodiments.
FIG. 11 is a layout diagram of an IC device, in accordance with some embodiments.
FIG. 12 is a layout diagram of an IC device, in accordance with some embodiments.
FIG. 13 is a flow diagram of a method of manufacturing an IC device, in accordance with some embodiments.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

Embodiments of an integrated circuit (IC) device are disclosed. The IC device includes a semiconductor substrate (e.g., a silicon substrate), a buried oxide (BOX) layer formed over the semiconductor substrate and a semiconductor layer formed over the BOX layer. Active semiconductor components are formed using active sections (e.g. drains and sources of field effect transistors (FETs) to help dissipate the heat out of the IC device, extended sections are formed in the semiconductor layer. The extended sections extend from the active sections of the active semiconductor devices. The extended sections thereby provide horizontal thermal conduction out of the active semiconductor devices. Thermal heat sinks are formed over the extended sections to vertically conduct heat out of the IC device.

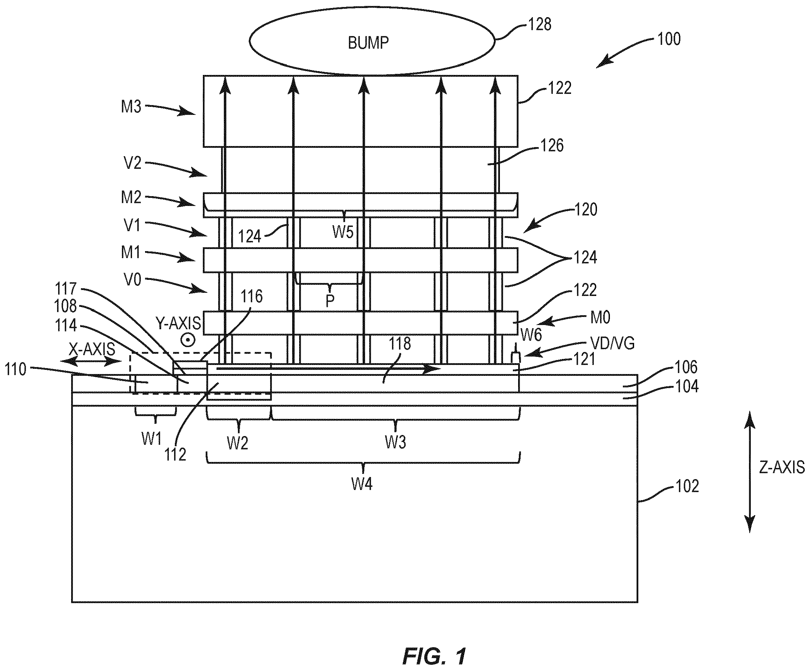

FIG. 1 is a cross-sectional diagram of an integrated circuit (IC) device 100, in accordance with some embodiments.

The IC device 100 is formed as part of an IC. The IC includes a semiconductor substrate 102, a buried oxide (BOX) layer 104, and a semiconductor layer 106. In this embodiment, the semiconductor substrate 102 has a body formed from silicon. In other embodiments, the body of the semiconductor substrate 102 includes silicon germanium (SiGe), gallium arsenide (GaAs), or other suitable semiconductor materials. Conductive features may be integrated into the body of the semiconductor substrate 102. The BOX layer 104 is an insulating layer. The BOX layer 104 is formed from an oxide material. For example, the BOX layer 104 is formed from a silicon oxide, such as SiO, SiO₂, SiO₃, in accordance with some embodiments. In this embodiment, the semiconductor layer 106 is formed from silicon. In other embodiments, the semiconductor layer 106 is formed from SiGe, GaAs, or other suitable semiconductor materials.

The layers 102, 104, 106 of the IC device 100 are stacked over one another in a vertical direction, which in this embodiment is parallel to the z-axis. Active semiconductor devices are formed using the semiconductor layer 106. For example, a field effect transistor (FET) 108 is formed with the semiconductor layer 106. More specifically, the FET 108 includes a drain formed by an active section 110 in the semiconductor layer 106. The FET 108 further includes a source formed by an active section 112 in the semiconductor layer 106. A channel region 114 disposed in the semiconductor layer 106 between the active section 110 and the active section 112 (relative to the x-axis, see below). A gate 116 is formed directly over the channel region 114 relative to the z-axis. A dielectric layer 117 is provided between the gate 116 and the channel region 114 in the semiconductor layer 106 relative to the z-axis. Example materials of the dielectric layer 117 include, but are not limited to, a high-k dielectric layer, an interfacial layer, and/or combinations thereof. In some embodiments, the dielectric layer 117 is deposited over the substrate by atomic layer deposition (ALD) or other suitable techniques. The gate 116 is deposited over the dielectric layer 117. Example materials of the gate 116, but are not limited to, polysilicon, metal, Al, AlTi, Ti, TiN, TaN, Ta, TaC, TaSiN, W, WN, MoN, and/or other suitable conductive materials.

The layers 102, 104, 106 of the IC device 100 are stacked over one another in a vertical direction, which in this embodiment is parallel to the z-axis. The gate 116 extends in a horizontal direction, which in this embodiment is parallel to the y-axis (shown going into the page in FIG. 1). The z-axis is orthogonal to the y-axis. Another horizontal direction is parallel to the x-axis. The x-axis, the y-axis, and the z-axis are all orthogonal to one another.

The BOX layer 104 is formed over and on the semiconductor substrate 102 relative to the z-axis while the semiconductor layer 106 is formed over and on the BOX layer 104 relative to the z-axis. The BOX layer 104 is thus formed between the semiconductor substrate 102 and the semiconductor layer 106 relative to the z-axis. In some embodiments, the thermal conductivity of the BOX layer 104 is less than the thermal conductivity of the semiconductor substrate 102. In some embodiments, the thermal conductivity of the BOX layer 104 is less than the thermal conductivity of the semiconductor layer 106. Thus, the IC device 100 implements techniques to remove heat generated in the semiconductor layer 106, horizontally using an extended section 118 and then vertically using a thermal heat sink 120. In this embodiment, the layers 102, 104, 106, 118 and the gate 116 are formed in the Front End of Line (FEOL) of the IC device 100 while the thermal heat sink 120 is formed in the Back End of Line (BEOL) of the IC device 100.

The extended section 118 is formed in the semiconductor layer 106. The extended section 118 is also an active section that extends from the active section 112 of the FET 108. In this embodiment, the extended section 118 and the active section 112 are integrated to form a larger active region. The extended section 118 thus provides a horizontal path for the conductance of heat. The thermal heat sink 120 then conducts the heat vertically so that the heat is conducted externally out of the IC device 100.

The active section 110 that forms the drain of the FET 108 has a width W1 relative to the X-axis. The active section 112 that forms the source of the FET 108 has a width W2 relative to the x-axis. The active section 112 that forms the source of the FET 108 has a width W2 relative to the x-axis. The extended section 118 has a width W3 relative to the x-axis. The width W2 added to the width W3 is the width W4 relative to the x-axis. The width W4 is at least five times greater than the width W1. This additional width W3 provided by the extended section 118 that is added to width W2 of the active section 112 provides the additional thermal conductive path needed to horizontally conduct heat since, in some embodiments, the thermal conductivity of the BOX layer 104 is low and cannot conduct vertically in an efficient manner through the BOX layer 104. In FIG. 1, a silicide layer 121 is formed directly over the active section 112 and the extended section 118.

In FIG. 1, the thermal heat sink 120 is formed from metal plates 122 (not all labeled for the sake of brevity and clarity) and conductive vias 124 (not all labeled for the sake of brevity and clarity). In this embodiments, conductive vias 124 are formed in a VD/VG via layer. The conductive vias 124 in the VD/VG via layer are formed on and over the silicide layer 121. In other embodiments, rather than having the row of conductive vias 124, one large conductive via with a diameter that expands across the active section 112 and the extended region is used. The metal plate 122 is formed in the metal layer M0 over and on the conductive vias 124 that are formed in the VD/VG via layer. In other embodiments, rather than the metal plate 122, various metal segments are provided individually to connect pairs of the conductive vias 124 that are directly between one another.

In this embodiment, the conductive vias 124 are formed in a V0 via layer. The conductive vias 124 in the V0 via layer are formed on and over the metal plate 122 in the M0 layer. In other embodiments, rather than having the row of the conductive vias 124, one large conductive via with a diameter that expands across the active section 112 and the extended region is used. The metal plate 122 is formed in the metal layer M1 over and on the conductive vias 124 that are formed in the V0 via layer. In other embodiments, rather than the metal plate 122, various metal segments are provided individually to connect pairs of the conductive vias 124 that are directly between one another.

In this embodiment, the conductive vias 124 are formed in a V1 via layer. The conductive vias 124 in the V1 via layer are formed on and over the metal plate 122 in the M1 layer. In other embodiments, rather than having the row of the conductive vias 124, one large conductive via with a diameter that expands across the active section 112 and the extended region is used. The metal plate 122 is formed in the metal layer M2 over and on the conductive vias 124 that are formed in the V0 via layer. In other embodiments, rather than the metal plate 122, various metal segments are provided individually to connect pairs of the conductive vias 124 that are directly between one another.

In this embodiment, a large conductive vias 126 is formed in a V2 via layer. The conductive via in the V2 via layer are formed on and over the metal plate 122 in the M2 layer. In other embodiments, a row of conductive vias is provided. The metal plate 122 is formed in a metal layer M3 over and on the conductive via 126. In other embodiments, rather than the metal plate 122, various metal segments are provided individually to connect pairs of the conductive vias 124 that are directly between one another.

According to the claimed invention, a solder bump 128 is provided on and over the metal plate 122. The solder bump 128 is used to connect the metal plate 122 in the M3 layer to a ground plate. Accordingly, in this embodiment, the FET 108 is an N-channel FET (NFET). The extended section 118 is simply an extension of the active region 122 that forms the source and has the same doping as the active region 122. The active region 122 can thus connect directly to ground through the thermal heat sink. However, in other embodiments, the FET 108 is an P-channel FET (PFET). In this case, the extended section 118 would be formed of various subsection that form isolating components such as diodes. This is because the source of a PFET is not connected to ground. For example, the source of the PFET is connected to a power source voltage. Thus, the isolating components isolate the power source voltage from the ground connection provided through the thermal heat sink 120, as explained in further detail below.

It should be noted that the largest width W5 of the thermal heat sink 120 may be greater than or equal to the width W4. This ensures that the maximum amount of horizontal area is provided for thermal conduction through the extended section. Furthermore, each row of the conductive vias 124 should contact as much of the area over the extended section 118 and active section 112 as possible to increase thermal conduction. Thus, in FIG. 1, the width W6 of the material in the extended section 118 after the extreme most conductive vias 124 in the rows relative to the x-axis should be less than the pitch P between the conductive vias 124 (otherwise another conductive via 124 would fit in the row over the extended section 118 and thus the maximum area of conduction is not being provided by the row of conductive vias 124).

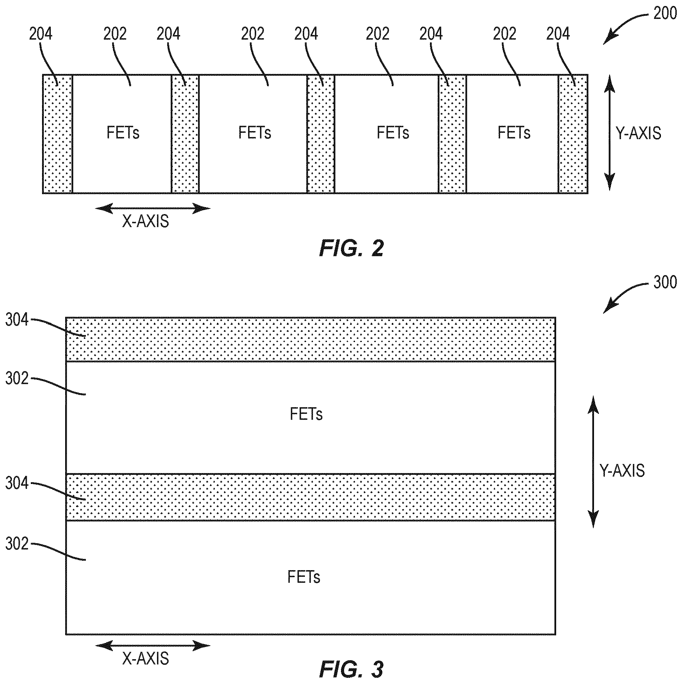

FIG. 2 is a diagram of an IC device 200, in accordance with some embodiments.

The IC device 200 has areas 202. The IC device 200 is formed on a semiconductor die having a semiconductor structure similar to the semiconductor structure shown in FIG. 1. Each of the areas 202 includes one or more FETs. In some embodiments, the FETs are NFETs. In other embodiments, the FETs are PFETs. In still other embodiments, some of the FETs are NFETs and some of the FETs are PFETs. More specifically, a semiconductor layer in the areas 202 provides active areas that form the drain and the sources of the FETs. Extended sections 204 are formed in the semiconductor layer and separate the areas 202. In FIG. 2, the extended sections 204 separate the areas 202 with respect to the x-axis. Thus, each of the areas 202 is separated by an extended section 204 relative to the x-axis.

The extended sections 204 conduct heat from the FETs in the areas 202 horizontally. Thermal heat sinks are formed on the extended sections 204 to conduct the heat vertically out of the IC device 200.

FIG. 3 is a diagram of an IC device 300, in accordance with some embodiments.

The IC device 300 has areas 302. The IC device 300 is formed on a semiconductor die having a semiconductor structure similar to the semiconductor structure shown in FIG. 1. Each of the areas 302 includes one or more FETs. In some embodiments, the FETs are NFETs. In other embodiments, the FETs are PFETs. In still other embodiments, some of the FETs are NFETs and some of the FETs are PFETs. More specifically, a semiconductor layer in the areas 302 provides active sections that form the drain and the sources of the FETs. Extended sections 304 are formed in the semiconductor layer and separate the areas 302. In FIG. 3, the extended sections 304 separate the areas 302 with respect to the y-axis. Thus, each of the areas 302 is separated by an extended section 304 relative to the y-axis.

The extended sections 304 conduct heat from the FETs in areas 302 horizontally. Thermal heat sinks are formed on the extended sections 304 to conduct the heat vertically out of the conductive device 300.

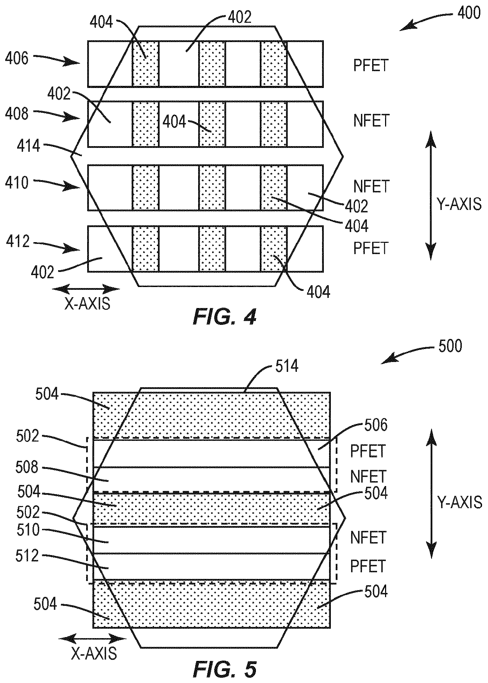

FIG. 4 is a diagram of an IC device 400, in accordance with some embodiments.

The IC device 400 is an example of the IC device 200, in accordance with some embodiments. Accordingly, areas 402 (not all labeled for the sake of clarity) include FETs and are separated by extended sections 404 (not all labeled for the sake of clarity) with respect to the x-axis. A semiconductor layer in the areas 402 provides active areas that form the drain and the sources of the FETs. In this embodiment, several rows 406, 408, 410, 412 of the areas 402 and the extended sections 404. The rows 406, 408, 410, 412 are separated from one another with respect to the y-axis. The areas 402 in row 406 and row 410 have NFETs (and no PFETs) while row 408 and row 412 have PFETs (and no NFETs).

In FIG. 4, the IC device 400 includes a ground plate 414. The ground plate 414 is configured to have a potential at ground. The ground plate 414 is positioned so as to be vertically displaced from the areas 402 and extended sections 404 with respect to the z-axis. Each of the extended sections 404 includes a thermal heat sink (not explicitly shown) that connects the extended sections 404 to the ground plate 414. With respect to the extended sections 404 in the rows 406, 410 having the areas 402 with the PFETs, the extended sections 404 include isolating devices to prevent the sources connected to power source voltage from the ground potential at the ground plate 414.

FIG. 5 is a diagram of an IC device 500, in accordance with some embodiments.

The IC device 500 is an example of the IC device 300, in accordance with some embodiments. Accordingly, areas 502 include FETs and are separated by extended regions 504 (not all labeled for the sake of clarity) with respect to the y-axis. A semiconductor layer in the areas 502 provides active areas that form the drain and the sources of the FETs. In this embodiment, one of the areas 502 includes a subarea 506 and a subarea 508. The subarea 506 and the subarea 508 are adjacent to one another but in different positions relative to the y-axis. More specifically, the subarea 506 is positioned closer to an end 511 of the IC device 500 while the subarea 508 is positioned closer to an end 513 of the IC device 500. The ends 511, 513 are separated with respect to the y-axis. In this embodiment, the subarea 506 includes PFETs while the subarea 508 includes NFETs.

In this embodiment, another one of the areas 502 includes a subarea 510 and a subarea 512. The subarea 510 and the subarea 512 are adjacent to one another but in different positions relative to the y-axis. More specifically, the subarea 510 is positioned closer to the end 511 of the IC device 500 while the subarea 512 is positioned closer to the end 513 of the IC device 500. In this embodiment, the subarea 510 includes NFETs while the subarea 512 includes PFETs. In this manner, the subarea 508 and the subarea 510 with NFETs can share the extended area 504 between the subareas 508, 510.

In FIG. 5, the IC device 500 includes a ground plate 514. The ground plate 514 is configured to have a potential at ground. The ground plate 514 is positioned so as to be vertically displaced from the areas 502 and extended sections 504 with respect to the z-axis. Each of the extended sections 504 includes a thermal heat sink (not explicitly shown) that connects the extended sections 504 to the ground plate 514. With respect to the extended sections 504 in the subareas 506, 512 having the areas 502 with the PFETs, the extended sections 504 include isolating devices to prevent the sources connected to power source voltage from the ground potential at the ground plate 514. The extended area 504 between the subareas 508, 510 with the NFETs do not include isolating devices but rather is simply an extension of a source of one of the NFETs in the subareas 508, 510.

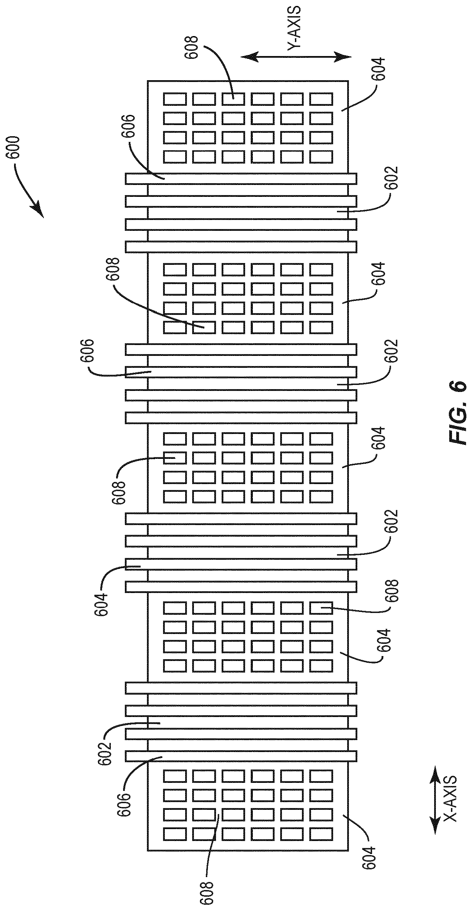

FIG. 6 is a diagram of an IC device 600, in accordance with some embodiments.

The IC device 600 is an example of the IC device 200, in accordance with some embodiments. Accordingly, areas 602 include FETs and are separated by extended regions 604 with respect to the x-axis. The areas 602 and the extended regions 604 are organized into a row.

Each of the areas 602 include 4 FETs. A semiconductor layer in the areas 602 provides active areas that form the drain and the sources of the FETs. In other embodiments, the areas 602 may include any number of FETs greater than or equal to 1. FIG. 6 shows gates 606 (not all labeled for the sake of clarity) of the FETs, which have a long axis with respect to the y-axis and a short axis with respect to the x-axis. Also shown are conductive vias 608 (not all labeled for the sake of clarity) in the VG/VD layer of the thermal heat sink (remainder of the thermal heat sink is not shown). As shown, rows and columns of the conductive vias 608 are provided to cover a maximum amount of the extended sections 604. In this manner, the conductive area of the thermal heat sink is increased to carry a greater amount of heat.

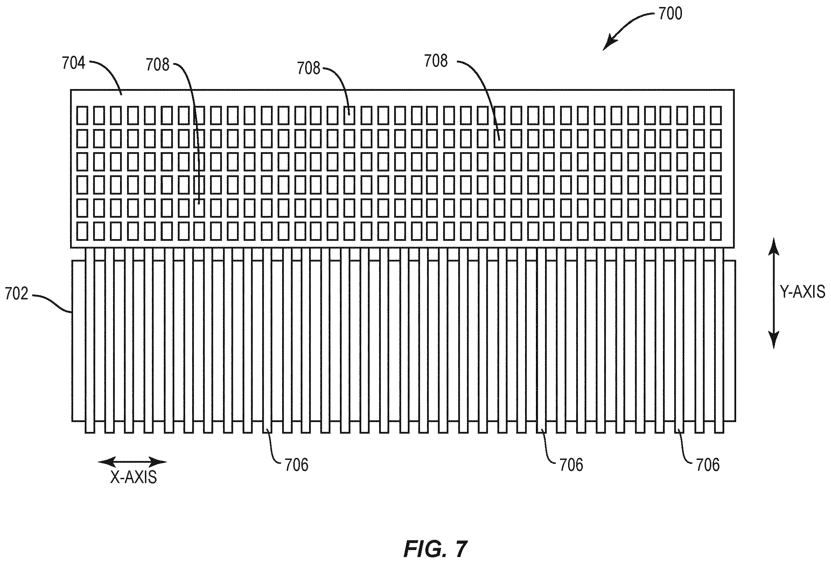

FIG. 7 is a diagram of an IC device 700, in accordance with some embodiments.

The IC device 700 is an example of the IC device 300, in accordance with some embodiments. Accordingly, an area 702 that includes FETs and an extended region 704 that is adjacent to but displaced from the area 702 with respect to the y-axis. The area 702 and extended section 704 are organized as a column. A semiconductor layer in the area 702 provides active areas that form the drain and the sources of the FETs.

FIG. 7 shows gates 706 (not all labeled for the sake of clarity) of the FETs, which have a long axis with respect to the y-axis and a short axis with respect to the x-axis. Also shown are conductive vias 708 (not all labeled for the sake of clarity) in the VG/VD layer of the thermal heat sink (remainder of the thermal heat sink is not shown). As shown, rows and columns of the conductive vias 708 are provided to cover a maximum amount of the extended section 704. In this manner, the conductive area of the thermal heat sink is increased to carry a greater amount of heat.

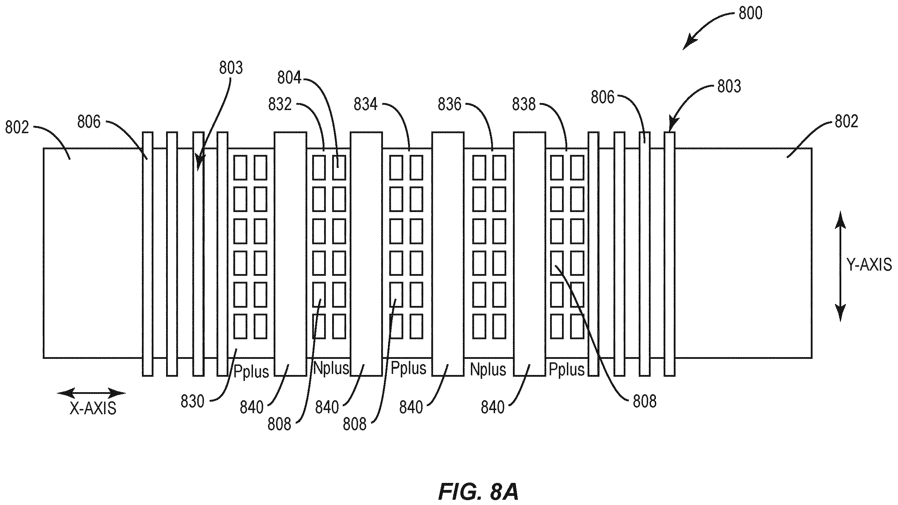

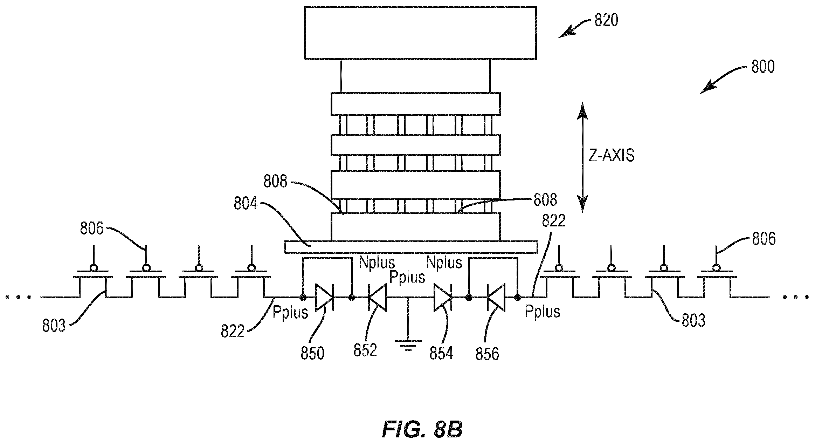

FIG. 8A and FIG. 8B are diagrams of an IC device 800, in accordance with some embodiments.

The IC device 800 is an example of the IC device 600 and the IC device 200, in accordance with some embodiments. Accordingly, areas 802 include FETs and are separated by extended regions 804 with respect to the x-axis. The areas 802 and extended sections 804 are organized into a row. A semiconductor layer in the areas 802 provides active areas that form the drain and the sources of the FETs.

FIG. 8A is a top view of the IC device 800 and illustrates the IC device 800 with respect to the x-axis and the y-axis. FIG. 8B illustrates a circuit diagram of the IC device 800 and a thermal heat sink 820 from one of the extended regions 804, as shown in respect to the z-axis. The thermal heat sink 820 is arranged in the same manner as the thermal heat sink 120 shown in FIG. 1 (except that the bump 128 is not shown in this embodiment). A thermal heat sink like the thermal heat sink 820 is provided on each of the extended regions 804 in accordance with some embodiments.

Each of the areas 802 include four (4) FETs 803 (not all labeled for the sake of clarity). In other embodiments, the areas 802 may include any number of FETs greater than or equal to 1. FIG. 8A shows gates 806 (not all labeled for the sake of clarity) of the FETs 803, which have a long axis with respect to the y-axis and a short axis with respect to the x-axis. Also shown are conductive vias 808 (not all labeled for the sake of clarity) in the VG/VD layer of the thermal heat sink 820. As shown, rows and columns of the conductive vias 808 are provided to cover a maximum amount of the extended sections 804. In this manner, the conductive area of the thermal heat sink 820 is increased to carry a greater amount of heat.

In this embodiment, each of the FETs 803 are PFETs. A drain 822 of the FETs 803 adjacent to the extended sections 804 is thus configured to be at a potential such as a power source voltage. Accordingly, the drain 822 of the FETs 803 that are adjacent to the extended section 804 has to be electrically isolated from the thermal heat sink 820 since the thermal heat sink 820 is at the ground potential. Therefore, in this embodiment, the extended section 804 includes subsections 830, 832, 834, 836, 838. The subsection 830 is directly adjacent to the areas 802 on the left. The subsection 830 has P-type doping (referred to in FIG. 8A and FIG. 8B as Pplus). The subsection 832 is directly adjacent to and between subsection 830 and subsection 834. The subsection 832 has N-type doping (referred to in FIG. 8A and FIG. 8B as Nplus). The subsection 834 is directly adjacent to and between the subsection 832 and the subsection 836. The subsection 834 has P-type doping. The subsection 836 is directly adjacent to and between the subsection 834 and the subsection 838. The subsection 836 has N-type doping. The subsection 838 is directly adjacent to the areas 802 on the right. The subsection 830 has P-type doping. Dummy gates 840 are formed at the borders of the adjacent subsections 830, 832, 834, 836, 838.

As such, the subsections 830 and 832 form a diode 850 with an anode at the subsection 830 and a cathode at subsection 832. In this embodiment, the anode and the cathode of the diode 850 are directly connected to one another through a parallel path. The subsections 832 and 834 form a diode 852 with a cathode at the subsection 832 and an anode at the subsection 832. The cathode of the diode 852 is connected to ground (e.g., a ground plate) through the thermal heat sink 820. The diode 852 thus isolates the drain 822 in the extended section 804 on the left from the ground potential provided at the thermal heat sink 820. The subsections 834 and 836 form a diode 854 with a cathode at the subsection 834 and an anode at subsection 836. The cathode of the diode 854 is connected to ground (e.g., a ground plate) through the thermal heat sink 820. The diode 854 thus isolates the drain 822 in the extended section 804 on the right from the ground potential provided at the thermal heat sink 820. The subsections 836 and 838 form a diode 856 with an anode at the subsection 836 and a cathode at subsection 838. In this embodiment, the anode and the cathode of the diode 856 are directly connected to one another through a parallel path. The diodes 852, 854 are thus isolation devices that isolate the FET 803 (which in this are PFETs) from the ground potential of the thermal heat sink 820. Thermal heat sink 820 thus provides thermal heat conduction through the extended sections while isolating the FETs 803 from the ground potential of the thermal heat sink 820. In an alternate embodiment, where the FETs 803 are NFETs, the extended section 804 would not have the subsections 830, 832, 834, 836, 838. Rather, the entire extended section 804 would simply be an extension of the drains 822 and have the same doping as the drains 822 since isolation is not used to isolate from the ground potential of the thermal heat sink 820.

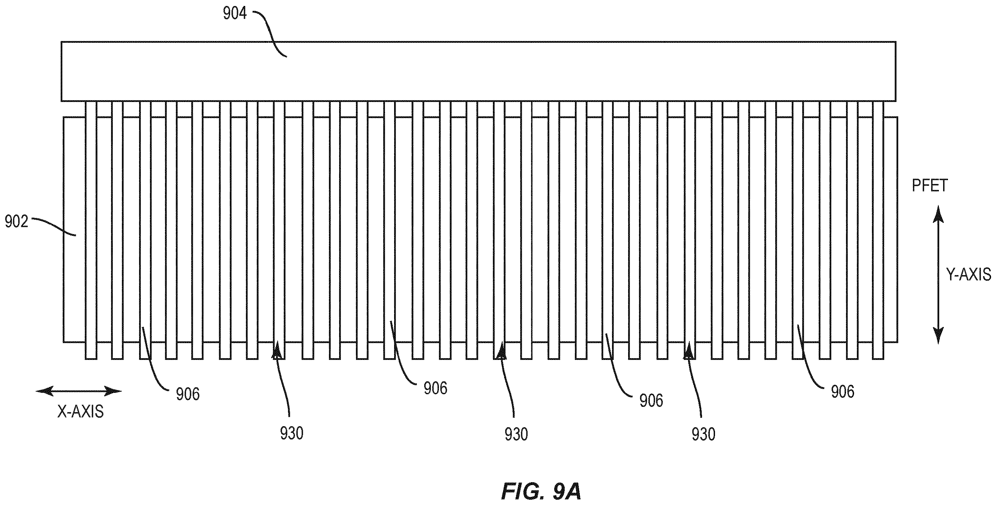

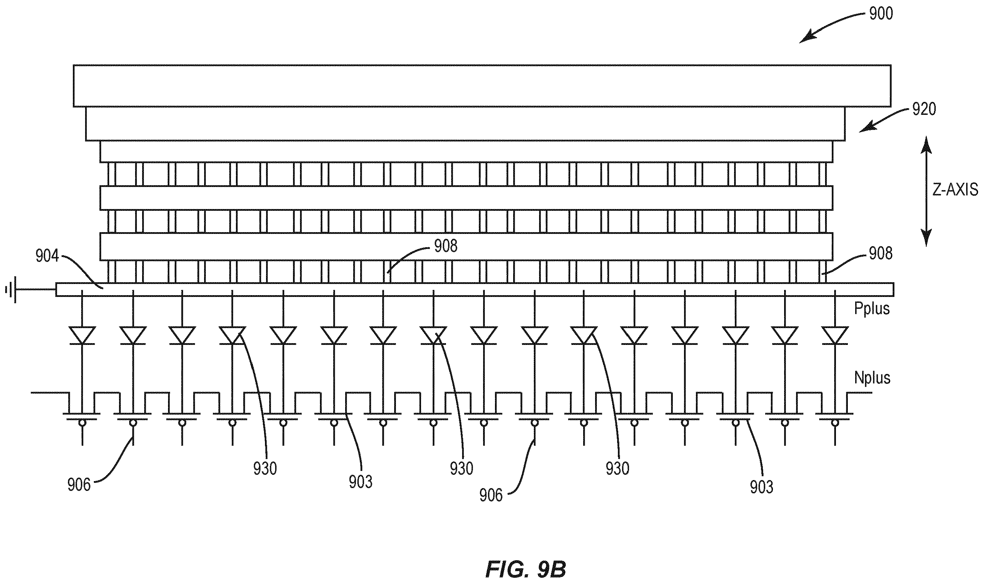

FIG. 9A and FIG. 9B are diagrams of an IC device 900, in accordance with some embodiments.

The IC device 900 is an example of the IC device 300, in accordance with some embodiments. Accordingly, an area 902 that includes FETs and an extended region 904 that is adjacent to but displaced from the area 902 with respect to the y-axis. The area 902 and the extended section 904 are organized as a column. A semiconductor layer in the area 902 provides active areas that form the drain and the sources of the FETs.

FIG. 9A and FIG. 9B show gates 906 (not all labeled for the sake of clarity) of the FETs, which have a long axis with respect to the y-axis and a short axis with respect to the x-axis. Also shown are conductive vias 908 (not all labeled for the sake of clarity) in the VG/VD layer of a thermal heat sink 920. FIG. 9A is a top view of the IC 900 and illustrates the IC device 900 with respect to the x-axis and the y-axis. FIG. 9B illustrates a circuit diagram of the IC device 900 and the thermal heat sink 920 formed on the extended region 904, as shown in respect to the z-axis. The thermal heat sink 920 is arranged in the same manner as the thermal heat sink 120 shown in FIG. 1 (except that the bump 128 is not shown in this embodiment).

The area 902 includes FETs 903 (not all labeled for the sake of clarity). In other embodiments, the area 902 may include any number of FETs greater than or equal to 1. FIG. 9A shows the gates 906 (not all labeled for the sake of clarity) of the FETs 903, which have a long axis with respect to the y-axis and a short axis with respect to the x-axis. Also shown are the conductive vias 908 (not all labeled for the sake of clarity) in the VG/VD layer of the thermal heat sink 920. Rows and columns of the conductive vias 908 are provided to cover a maximum amount of the extended sections 904. In this manner, the conductive area of the thermal heat sink 920 is increased to carry a greater amount of heat.

In this embodiment, each of the FETs 903 are PFETs. A diodes 930 are formed within the extended section. Each of the diodes 930 has a cathode connected to the thermal heat sink 920 and an anode connected to a body of one of the FETs 903. The diodes 930 thus isolate the FETs 903 from the ground potential of the thermal heat sink 920. In other embodiments, where the FETs 903 are NFETs, the diodes 930 are not provided and the bodies of the FETs 903 connect to the thermal heat sink 920, which is at the ground potential.

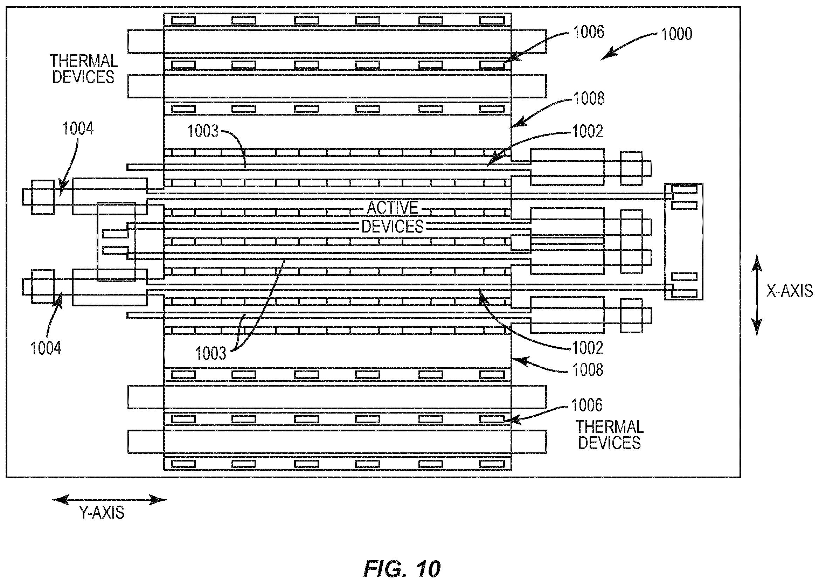

FIG. 10 is a layout diagram of an IC device 1000, in accordance with some embodiments.

The layout diagram includes shapes that represent components in the IC device 1000. The discussion of the diagram will refer to the components that are represented by the shapes, rather than discussing the shapes. It should be noted that these components are represented by shapes and that these shapes correspond to features on a mask used to form the components in an IC manufacturing process.

The IC device 1000 includes FETs 1002 (not all labeled for the sake of clarity), wherein the FETs 1002 include gates 1003 (not all labeled for the sake of clarity) that have a long axis that extends parallel to the y-axis. A semiconductor layer in the area with the FETs 1002 provides active areas that form the drain and the sources of the FETs. An extended section 1004 is spaced apart relative to the y-axis. Diodes are formed in the extended section 1004. The diode isolates the FETs 1002 from a thermal heat sink 1006. The thermal heat sink 1006 is formed over an extended section 1008 that is displaced relative to the x-axis from the FETs 1002.

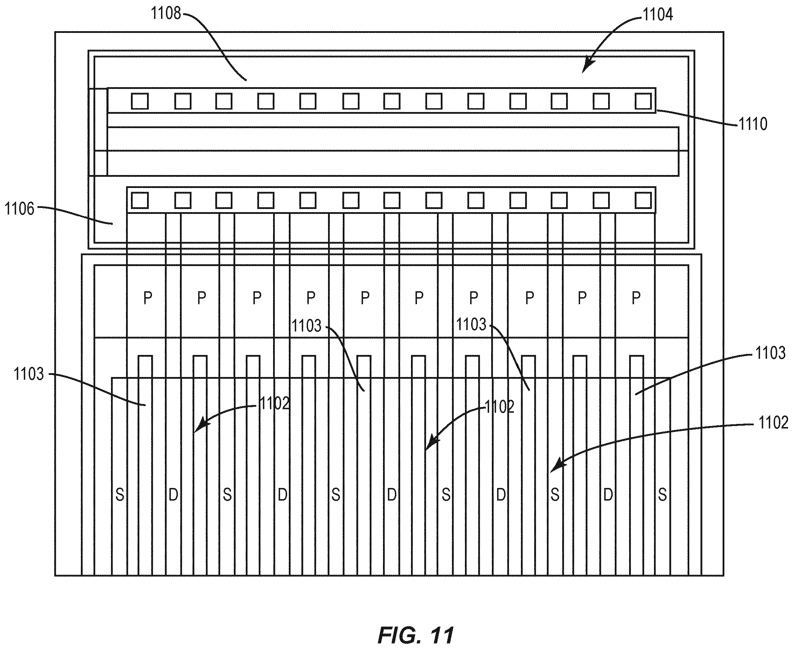

FIG. 11 is a layout diagram of an IC device 1100, in accordance with some embodiments.

The layout diagram includes shapes that represent components in the IC device 1100. The discussion of the diagram will refer to the components that are represented by the shapes, rather than discussing the shapes. It should be noted that these components are represented by shapes and that these shapes correspond to features on a mask used to form the components in an IC manufacturing process.

The IC device 1100 includes FETs 1102 (not all labeled for the sake of clarity), wherein the FETs 1102 include gates 1103 (not all labeled for the sake of clarity) that have a long axis that extends parallel to the y-axis. A semiconductor layer in the area with the FETs 1102 provides active areas that form the drain and the sources of the FETs 1102. An extended section 1104 is spaced apart relative to the y-axis. The extended section 1104 has a subsection 1006 that has N-type doping. The subsection 1106 forms the anode of a diode. A subsection 1108 has P-type doping and forms the cathode of the diode. A thermal heat sink 1110 is formed on and over the extended section 1104. The diode formed by the subsections 1106, 1108 isolates the thermal heat sink 1110 from the FETs 1102.

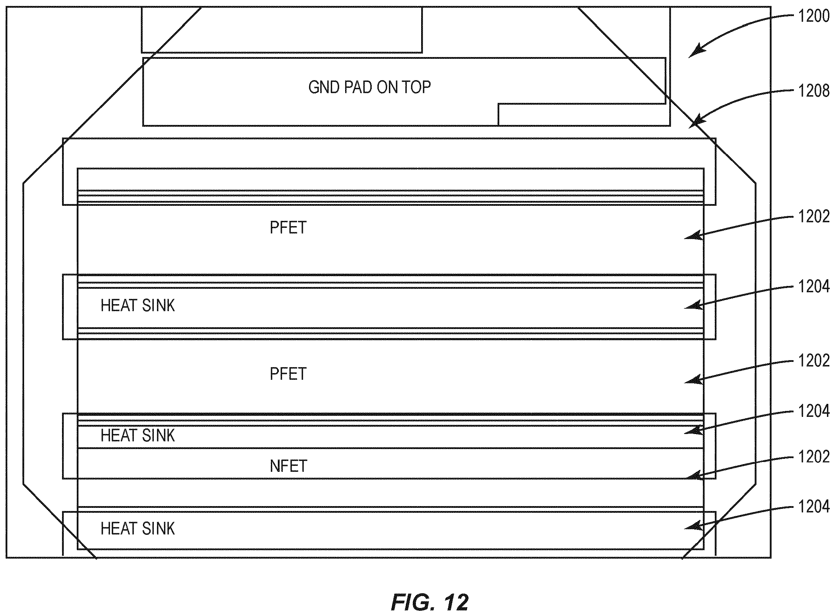

FIG. 12 is a layout diagram of an IC device 1200, in accordance with some embodiments.

The layout diagram includes shapes that represent components in the IC device 1200. The discussion of the diagram will refer to the components that are represented by the shapes, rather than discussing the shapes. It should be noted that these components are represented by shapes and that these shapes corresponds to features on a mask used to form the components in an IC manufacturing process.

The IC device 1200 is an embodiment of the IC device 300 shown in FIG. 3. The IC device 1200 has areas 1202. Each of the areas 1202 includes one or more FETs. The area 1202 lowest with respect to the page includes NFETs, while the two areas 1202 highest with respect to the page includes PFETs. Extended sections 1204 are formed in the semiconductor layer and separate the areas 1202. In FIG. 12, the extended sections 1204 separate the areas 1202 with respect to the y-axis. Thus, each of the areas 1202 is separated by an extended section 1204 relative to the y-axis. A semiconductor layer in the areas 1202 provides active areas that form the drain and the sources of the FETs.

The extended sections 1204 conduct heat from the FETs in the areas 302 horizontally. Thermal heat sinks are formed on the extended sections 1204 to conduct the heat vertically out of the conductive device 1200. In this embodiment, the top two extended sections 1204 relative to the page form isolation devices, such as diodes, that isolate the PFETs in the top two extended sections from the thermal heat sinks. The lowest most extended section 1204 relative to the page is simply an extension of the sources and is configured to be connected to ground through the thermal heat sink. The extended sections 1204 are connected to a ground plate 1208 through the thermal heat sinks.

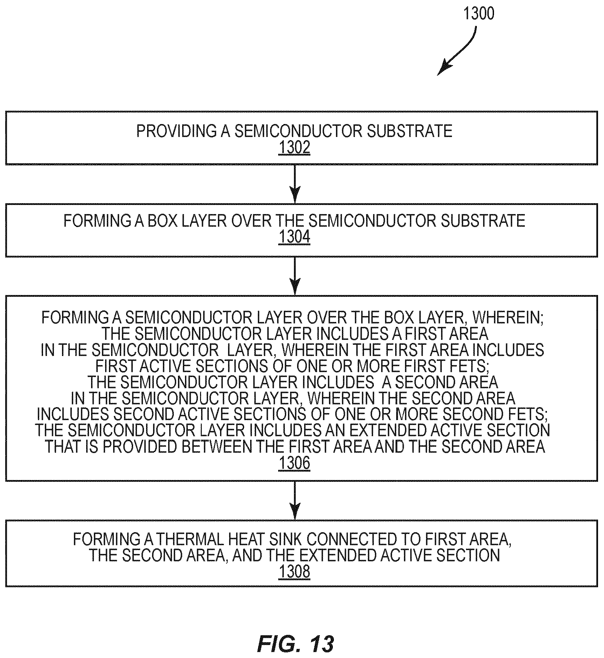

FIG. 13 is a flow diagram 1300 of a method of manufacturing an IC device, in accordance with some embodiments.

IC devices that are manufactured in accordance with the flow diagram 1300 include the IC devices 100, 200, 300, 400, 500, 600, 700, 800, 900, 1000, 1100, 1200 in FIG. 1-FIG. 12. The flow diagram 1300 includes blocks 1302-1308. Flow begins at block 1302.

At block 1302, a semiconductor substrate is provided. An example of the semiconductor substrate is the semiconductor substrate 102 shown in FIG. 1. Flow then proceeds to block 1304.

At block 1304, a BOX layer is formed over the semiconductor substrate. An example of the BOX layer is the BOX layer 104 in FIG. 1. Flow then proceeds to block 1306.

At block 1306, a semiconductor layer is formed over the BOX layer, wherein the semiconductor layer includes a first area in the semiconductor layer, wherein the first area includes first active sections of one or more first FETs; the semiconductor layer includes a second area in the semiconductor layer, wherein the second area includes second active sections of one or more second FETs; the semiconductor layer includes an extended active section that is provided between the first area and the second area. An example of the semiconductor layer is the semiconductor layer 106 in FIG. 1. Examples of the first area and the second area includes the active areas 202 in FIG. 2, the active areas 302 in FIG. 3, the active areas 402 in FIG. 4, the active areas 502, in FIG. 5, the active areas 602 in FIG. 6, the active area 702 in FIG. 7, the active areas 802 in FIG. 8A, the active area 902 in FIG. 9, the active area 1002 in FIG. 9, the active areas 1002 in FIG. 10, the active area in FIG. 11, and the active areas 1202 in FIG. 12. An example of the extended sections includes the extended sections 204 in FIG. 2, the extended sections 304 in FIG. 3, the extended sections 404 in FIG. 4, the extended sections 504 in FIG. 5, the extended sections 604 in FIG. 6, the extended section 704 in FIG. 7, the extended section 804 in FIG. 8A, the extended section 904 in FIG. 9A, the extended section 1106 in Fig. 10, the extended section 1104 in FIG. 11, the extended sections 1204 in FIG. 12. Flow then proceeds to block 1308.

At block 1308, a thermal heat sink connected to first area, the second area, and the extended active section is formed. An example of the thermal heat sink is the thermal heat sink 120 in FIG. 1, the thermal heat sink 820 in FIG. 8B, and the thermal heat sink 920 in FIG. 9B in accordance with some embodiments.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein.

## Claims

1. An integrated circuit, IC, device, comprising:
a semiconductor substrate (102);
a buried oxide (104), BOX, layer formed over the semiconductor substrate;
a semiconductor layer (106) formed over the BOX layer;
a field effect transistor (108), comprising:
a drain formed in a first active section of the semiconductor layer, the first active section having a first width with respect to a first horizontal direction;
a source formed in a second active section of the semiconductor layer, the second active section having a second width with respect to the first horizontal direction; and
an extended active section (118) that extends from the second active section, the extended active section having a third width relative to the first horizontal direction, wherein the second width added to the third width is equal to or greater than five times the first width;
a thermal heat sink (120) connected to the second active region and the extended active section and extending above the semiconductor layer;
a bump (128) attached to a top of the thermal heat sink; and
a ground plate connected to the thermal heat sink by the bump.

2. The IC device of claim 1, wherein:
the thermal heat sink has a fourth width with respect to the first horizontal direction, wherein the fourth width is substantially equal to the second width plus the third width.

3. The IC device of claim 1 or 2, wherein the extended active section is an extension of the source such that the second active section and the extended active section form an active region.

4. The IC device of claim 1, 2 or 3, wherein one or more diodes are formed in the extended active section.

5. An integrated circuit, IC, device, comprising:
a semiconductor substrate (102);
a buried oxide (104), BOX, layer formed over the semiconductor substrate;
a semiconductor layer (106) formed over the BOX layer;
a first area in the semiconductor layer, wherein the first area includes first active sections of one or more first field effect transistors (108), FETs;
a second area in the semiconductor layer, wherein the second area includes second active sections of the one or more second FETs;
an extended active section (118) that is provided between the first area and the second area; and
a thermal heat sink (120) connected to the first area, the second area, and the extended active section;
a bump (128) attached to a top of the thermal heat sink; and
a ground plate connected to the thermal heat sink by the bump.

6. The IC device of claim 5, wherein the extended active section is an extension of a first one of the first active sections in the first area and an extension of the first one of the second active sections of the first one of the one or more second FETs in the second area.

7. The IC device of claim 5 or 6, wherein one or more diodes are formed in the extended active section.

8. A method of manufacturing an integrated circuit, IC, device, comprising:
providing a semiconductor substrate (102);
forming a buried oxide (104), BOX, layer over the semiconductor substrate;
forming a semiconductor layer (106) over the BOX layer, wherein:
the semiconductor layer includes a first area in the semiconductor layer;
the first area includes first active sections of one or more first field effect transistors (108), FETs;
the semiconductor layer includes a second area in the semiconductor layer, wherein the second area includes second active sections of one or more second FETs;
the semiconductor layer includes an extended active section (118) that is provided between the first area and the second area; and
forming a thermal heat sink (120) connected to the first area, the second area, and the extended active section;
forming a bump (128) attached to a top of the thermal heat sink; and connecting a ground plate to the thermal heat sink by the bump.

## Patentansprüche

1. Integrierte-Schaltung- bzw. IC-Vorrichtung, die Folgendes umfasst:
ein Halbleitersubstrat (102);
eine Schicht eines vergrabenen Oxids (104) bzw. BOX-Schicht, die über dem Halbleitersubstrat gebildet ist;
eine Halbleiterschicht (106), die über der BOX-Schicht gebildet ist;
einen Feldeffekttransistor (108), der Folgendes umfasst:
einen Drain, der in einem ersten aktiven Abschnitt der Halbleiterschicht gebildet ist, wobei der erste aktive Abschnitt eine erste Breite mit Bezug auf eine erste horizontale Richtung aufweist;
eine Source, die in einem zweiten aktiven Abschnitt der Halbleiterschicht gebildet ist, wobei der zweite aktive Abschnitt eine zweite Breite in Bezug auf die erste horizontale Richtung aufweist; und
einen erweiterten aktiven Abschnitt (118), der sich von dem zweiten aktiven Abschnitt erstreckt, wobei der erweiterte aktive Abschnitt eine dritte Breite relativ zu der ersten horizontalen Richtung aufweist, wobei die zweite Breite addiert mit der dritten Breite gleich oder größer als das Fünffache der ersten Breite ist;
eine Wärmesenke (120), die mit dem zweiten aktiven Gebiet und dem erweiterten aktiven Abschnitt verbunden ist und sich über der Halbleiterschicht erstreckt;
einen Höcker (128), der an einer Oberseite der Wärmesenke befestigt ist; und
eine Masseplatte, die durch den Höcker mit der Wärmesenke verbunden ist.

2. IC-Vorrichtung nach Anspruch 1, wobei:
die Wärmesenke eine vierte Breite in Bezug auf die erste horizontale Richtung aufweist, wobei die vierte Breite im Wesentlichen gleich der zweiten Breite plus der dritten Breite ist.

3. IC-Vorrichtung nach Anspruch 1 oder 2, wobei der erweiterte aktive Abschnitt eine Erweiterung der Source ist, sodass der zweite aktive Abschnitt und der erweiterte aktive Abschnitt ein aktives Gebiet bilden.

4. IC-Vorrichtung nach Anspruch 1, 2 oder 3, wobei eine oder mehrere Dioden in dem erweiterten aktiven Abschnitt gebildet sind.

5. Integrierte-Schaltung- bzw. IC-Vorrichtung, die Folgendes umfasst:
ein Halbleitersubstrat (102);
eine Schicht eines vergrabenen Oxids (104) bzw.
BOX-Schicht, die über dem Halbleitersubstrat gebildet ist;
eine Halbleiterschicht (106), die über der BOX-Schicht gebildet ist;
einen ersten Bereich in der Halbleiterschicht, wobei der erste Bereich erste aktive Abschnitte eines oder mehrerer erster Feldeffekttransistoren (108) bzw. FETs beinhaltet;
einen zweiten Bereich in der Halbleiterschicht, wobei der zweite Bereich zweite aktive Abschnitte des einen oder der mehreren zweiten FETs beinhaltet;
einen erweiterten aktiven Abschnitt (118), der zwischen dem ersten Bereich und dem zweiten Bereich bereitgestellt ist; und
eine Wärmesenke (120), die mit dem ersten Bereich, dem zweiten Bereich und dem erweiterten aktiven Abschnitt verbunden ist;
einen Höcker (128), der an einer Oberseite der Wärmesenke befestigt ist; und
eine Masseplatte, die durch den Höcker mit der Wärmesenke verbunden ist.

6. IC-Vorrichtung nach Anspruch 5, wobei der erweiterte aktive Abschnitt eine Erweiterung eines ersten der ersten aktiven Abschnitte in dem ersten Bereich und eine Erweiterung des ersten der zweiten aktiven Abschnitte des ersten des einen oder der mehreren zweiten FETs in dem zweiten Bereich ist.

7. IC-Vorrichtung nach Anspruch 5 oder 6, wobei eine oder mehrere Dioden in dem erweiterten aktiven Abschnitt gebildet sind.

8. Verfahren zum Herstellen einer Integrierte-Schaltung- bzw. IC-Vorrichtung, das Folgendes umfasst:
Bereitstellen eines Halbleitersubstrats (102);
Bilden einer Schicht eines vergrabenen Oxids (104) bzw. BOX-Schicht über dem Halbleitersubstrat;
Bilden einer Halbleiterschicht (106) über der BOX-Schicht, wobei:
die Halbleiterschicht einen ersten Bereich in der Halbleiterschicht beinhaltet;
der erste Bereich erste aktive Abschnitte eines oder mehrerer erster Feldeffekttransistoren (108) bzw. FETs beinhaltet;
die Halbleiterschicht einen zweiten Bereich in der Halbleiterschicht beinhaltet, wobei der zweite Bereich zweite aktive Abschnitte des einen oder der mehreren zweiten FETs beinhaltet;
die Halbleiterschicht einen erweiterten aktiven Abschnitt (118) beinhaltet, der zwischen dem ersten Bereich und dem zweiten Bereich bereitgestellt ist; und Bilden einer Wärmesenke (120), die mit dem ersten Bereich, dem zweiten Bereich und dem erweiterten aktiven Abschnitt verbunden ist;
Bilden eines Höckers (128), der an einer Oberseite der Wärmesenke befestigt ist; und
Verbinden einer Masseplatte mit der Wärmesenke durch den Höcker.

## Revendications

1. Dispositif à circuit intégré, IC, comprenant :
un substrat semi-conducteur (102) ;
une couche d'oxyde enterrée (104), BOX, formée sur le substrat semi-conducteur ;
une couche semi-conductrice (106) formée sur la couche BOX ;
un transistor à effet de champ (108), comprenant :
un drain formé dans une première section active de la couche semi-conductrice, la première section active présentant une première largeur par rapport à une première direction horizontale ;
une source formée dans une deuxième section active de la couche semi-conductrice, la deuxième section active présentant une deuxième largeur par rapport à la première direction horizontale ; et
une section active étendue (118) qui s'étend à partir de la deuxième section active, la section active étendue présentant une troisième largeur par rapport à la première direction horizontale, la deuxième largeur ajoutée à la troisième largeur étant égale ou supérieure à cinq fois la première largeur ;
un dissipateur thermique (120) connecté à la deuxième région active et à la section active étendue et s'étendant au-dessus de la couche semi-conductrice ;
une bosse (128) fixée à une partie supérieure du dissipateur thermique ; et
une plaque de masse connectée au dissipateur thermique par la bosse.

2. Dispositif à circuit intégré selon la revendication 1, dans lequel :
le dissipateur thermique présente une quatrième largeur par rapport à la première direction horizontale, la quatrième largeur étant sensiblement égale à la deuxième largeur plus la troisième largeur.

3. Dispositif à circuit intégré selon la revendication 1 ou 2, dans lequel la section active étendue est une extension de la source de sorte que la deuxième section active et la section active étendue forment une région active.

4. Dispositif à circuit intégré selon la revendication 1, 2 ou 3, dans lequel une ou plusieurs diodes sont formées dans la section active étendue.

5. Dispositif à circuit intégré, IC, comprenant :
un substrat semi-conducteur (102) ;
une couche d'oxyde enterré (104),
BOX, formée sur le substrat semi-conducteur ;
une couche semi-conductrice (106) formée sur la couche BOX ;
une première zone dans la couche semi-conductrice, la première zone comprenant des premières sections actives d'un ou plusieurs premiers transistors à effet de champ (108), FET ;
une deuxième zone dans la couche semi-conductrice, la deuxième zone comprenant des deuxièmes sections actives du ou des deuxièmes FET ;
une section active étendue (118) qui est prévue entre la première zone et la deuxième zone ; et
un dissipateur thermique (120) connecté à la première zone, à la deuxième zone et à la section active étendue ;
une bosse (128) fixée à une partie supérieure du dissipateur thermique ; et
une plaque de masse connectée au dissipateur thermique par la bosse.

6. Dispositif à circuit intégré selon la revendication 5, dans lequel la section active étendue est une extension d'une première des premières sections actives dans la première zone et une extension de la première des deuxièmes sections actives de la première du ou des deuxièmes FET dans la deuxième zone.

7. Dispositif à circuit intégré selon la revendication 5 ou 6, dans lequel une ou plusieurs diodes sont formées dans la section active étendue.

8. Procédé de fabrication d'un dispositif à circuit intégré, IC, comprenant :
la fourniture d'un substrat (102) ;
la formation d'une couche d'oxyde enterré (104), BOX, sur le substrat semi-conducteur ;
la formation d'une couche semi-conductrice (106) sur la couche BOX, dans lequel :
la couche semi-conductrice comprend une première zone dans la couche semi-conductrice ;
la première zone comprend des premières sections actives d'un ou plusieurs premiers transistors à effet de champ (108), FET ;
la couche semi-conductrice comprend une deuxième zone dans la couche semi-conductrice, la deuxième zone comprenant des deuxièmes sections actives d'un ou plusieurs deuxièmes transistors FET ;
la couche semi-conductrice comprend une section active étendue (118) située entre la première et la deuxième zone ; et
la formation d'un dissipateur thermique (120) reconnecté à la première zone,à la deuxième zone et à la section active étendue ;
la formation d'une bosse (128) fixée à un sommet du dissipateur thermique ; et
la connexion d'une plaque de mise à la terre au dissipateur thermique par la bosse.
